# EUROPÄISCHE PATENTSCHRIFT

(11) **EP 3 630 579 B1**
(45) Veröffentlichungstag und Bekanntmachung des Hinweises auf die Patenterteilung: **02.03.2022**
(21) Anmeldenummer: 18728830.3
(22) Anmeldetag: 25.05.2018
(51) Int. Cl.: B62D 5/04, H02K 5/22, H02K 11/33

(54) **ELEKTRONISCHE STEUEREINHEIT FÜR EINE LENKKRAFTUNTERSTÜTZUNGSEINHEIT**
ELECTRONIC CONTROL UNIT FOR A POWER STEERING UNIT
UNITÉ DE COMMANDE ÉLECTRONIQUE POUR UNE UNITÉ DE DIRECTION ASSISTÉE

(30) Priorität: 30.05.2017 DE 102017111796
(43) Veröffentlichungstag der Anmeldung: 08.04.2020
(73) Patentinhaber: thyssenkrupp Presta AG, 9492 Eschen (LI); thyssenkrupp AG, 45143 Essen (DE)
(72) Erfinder: STECK, Philippe, 9487 Gamprin-Bendern (LI); ASENSIO, Francisco, CH-9320 Arbon (CH); BLANK, Katrin, 6822 Satteins (AT)
(74) Vertreter: thyssenkrupp Intellectual Property GmbH
(86) Internationale Anmeldenummer: PCT/EP2018/063808
(87) Internationale Veröffentlichungsnummer: WO 2018/219819

(56) Entgegenhaltungen:
- EP-A2- 2 500 986
- JP-A- 2002 010 567

## Beschreibung

Die vorliegende Erfindung betrifft eine elektronische Steuereinheit mit den Merkmalen des Oberbegriffs des Anspruchs 1.

Bei Kraftfahrzeugen sind Hilfskraftlenkung oder Servolenkungen zunehmend mit einer elektromotorisch angetriebenen Lenkkraftunterstützungseinheit versehen. Diese Einheit kann an verschiedenen Stellen des Lenksystems vorgesehen sein, nämlich an der Lenksäule, am Lenkritzel oder an der Zahnstange. In allen Fällen ist es vorteilhaft, die elektronische Steuereinheit, die den Elektromotor unmittelbar ansteuert, in einer Baugruppe mit dem Elektromotor zu integrieren. Da diese Baugruppe im Bereich der Achse oder im Motorraum angeordnet ist, sind besondere Anforderungen hinsichtlich der Dichtigkeit der Steuereinheit zu beachten. Insbesondere soll verhindert werden, dass Partikel oder Wasser in die Steuereinheit eindringen können. Aus der Druckschrift DE 102013104358 A1 ist es bekannt, die elektronische Steuereinheit mit einem Deckel dicht zu verschließen. Die Steuereinheit sitzt dabei in einem separaten Gehäuse, das mit einer staubdicht mit dem Gehäuse zusammenwirkenden Bodenplatte verschließbar ist.

In der Praxis zeigt sich jedoch, dass selbst diese Gehäuseausbildung nicht in allen Fällen ausreichend dicht ist.

Aus der EP 2 500 986 A2, welche als nächster Stand der Technik im Hinblick auf die unabhängigen Ansprüche angesehen wird, ist es bekannt, eine elektronische Steuereinheit wasserdicht zu verschließen. Auch hier sitzt die Steuereinheit in einem Gehäuse. Durch Einfüllung und Aushärtung eines Vergussharzes zwischen dem eingeführten Kabel und dem Gehäuseabschnitt wird eine Abdichtung erreicht.

Ausgehend hiervon ist es Aufgabe der vorliegenden Erfindung, eine elektronische Steuereinheit derart auszugestalten, dass auch bei externer Beaufschlagung mit Wasser und Partikeln die Betriebssicherheit nicht beeinträchtigt ist. Es soll auch verhindert werden, dass bereits in der Steuereinheit befindliche Partikel die Funktion der elektronischen Steuerung beeinträchtigen.

Diese Aufgabe wird von einer elektronischen Steuereinheit mit den Merkmalen des Anspruchs 1 oder 2 gelöst.

Weil bei einer elektronischen Steuereinheit für eine Lenkkraftunterstützungseinheit mit einem mehrteiligen Gehäuse, das eine in einem Innenraum des Gehäuses angeordnete elektronische Schaltung umschließt, und mit wenigstens einem Steckkontakt, der eine Anzahl das Gehäuse durchsetzende elektrische Leiter aufweist, die außerhalb des Innenraums angeordnete Kontaktflächen aufweisen und in den Innenraum hinein reichen, wo sie mit der elektronischen Schaltung verbunden sind, der Innenraum teilweise oder ganz mit einem geschlossenporigen Schaum ausgeschäumt ist, der ein elastischer Schaum mit einer Reißdehnung von mehr als 5% ist, vorzugsweise mit einer Reißdehnung von mindestens 10%, weiter bevorzugt von mindestens 20%, wird auch bei mechanischer Beanspruchung durch Vibrationen oder Temperaturänderungen der Schaum und dadurch auch die elektronischen Komponenten der Steuereinheit im Einzelnen als auch die gesamte Steuereinheit nicht geschädigt. Insbesondere bleiben eingeschlossene Partikel sicher im Schaum fixiert, sodass metallische Partikel keinen Kurzschluss verursachen können und es entstehen keine Partikel aus dem Schaummaterial infolge von Brüchen der Schaumstruktur. Es wird bevorzugt, dass die Reißdehnung des Schaums mindestens 40% beträgt. Die Reißdehnung gibt dabei an, um wie viel Prozent der Schaum gedehnt werden kann, bevor es zu einem Bruch kommt. Als elastischer Schaum eignet sich dabei besonders bevorzugt ein Einkomponentenschaum. Es ist aber auch denkbar und möglich einen Zweikomponentenschaum zu verwenden. Wenn der Schaum Blasen mit einem Durchmesser von im Mittel weniger als 1 mm, vorzugsweise weniger als 0,1 mm enthält, ergibt sich ein besonders vorteilhaftes Bindevermögen für eingeschlossene Partikel und zusätzlich eine besonders gute Abdichtung gegen von außen eindringende Partikel. Besonders bevorzugt hat das ungeschäumte Schaummaterial eine geringe Dichte von weniger als 1000 kg/m³, insbesondere weniger als 750kg/m³, sodass der Schaum ein geringes Gewicht hat oder anders ausgedrückt, leicht ist. Im ausgeschäumten Zustand bei

Kontakt mit Luft verringert sich das Gewicht des Schaums, wobei die Dichte des Schaums bevorzugt kleiner als 40kg/m³, bevorzugt kleiner als 10kg/m³ ist. Dadurch wirkt sich der Einsatz des Schaums auf das Gewicht der Steuereinheit nur geringfügig aus.

Dabei weist der Schaum bevorzugt zwischen 1.000 und 100.000 Blasen pro cm³ auf, wodurch sich ein vorteilhaftes Verhältnis aus Dicht- und Bindefunktion und Gewicht ergibt.

Bei einer bevorzugten Ausführungsform weist der Schaum bei einer mittleren Blasengröße von weniger als 0,1 mm zwischen 100.000 und 800.000 Blasen pro cm³ auf, insbesondere zwischen 400.000 und 800.000 Blasen pro cm³. Ein solcher feinporiger Schaum kann eine besonders gute Wärmeleitung gewährleisten.

Einer Rissbildung oder einer Rissausbreitung innerhalb des Schaums kann auch bei hohen Belastungen vorgebeugt werden, wenn der Schaum ein Kunstharzschaum mit eingebetteten Partikeln aus einem gummielastischen Material, beispielsweise aus Ethylen-Propylen-Dien-(Monomer)-Kautschuk (EPDM) oder Acrylnitril-Butadien-Kautschuk, kurz auch Nitrilkautschuk (Kurzzeichen AB und NBR), ist. Anrisse des Materials enden bei derart ausgestatteten Schäumen, sobald sie einen solchen eingebetteten Partikel erreichen.

Vorzugsweise ist der Schaum nicht vollständig vernetzt und bei Rissbildung selbstreparierend. Selbstreparierend meint dabei, dass der Schaum als nicht vollständig vernetzter Schaum ausgebildet ist. Diese Ausführung hat im Betrieb den Vorteil, dass auch langfristig über die gesamte vorgesehene Betriebsdauer der Steuereinheit eventuell entstehende Risse oder andere strukturelle Schäden in dem Schaum durch dann fortschreitende Vernetzung selbsttätig geheilt werden können.

Die Wärmeleitfähigkeit wird verbessert, wenn der Schaum Graphitpartikel als Füllstoff enthält. Es wird dabei bevorzugt, wenn der Schaum zwischen 3 Gew.% und 20 Gew.%, insbesondere 4 Gew.%, Graphitpartikel enthält. Eine lokale Erwärmung von eingebetteten Komponenten wird dadurch vermieden.

Die Wärmekapazität wird verbessert, wenn der Schaum Paraffin als Füllstoff enthält. Es wird dabei bevorzugt, wenn der Schaum zwischen 3 Gew.% und 20 Gew.%, insbesondere 5 Gew.%, Paraffin enthält. Dadurch kann der Schaum kurzfristig auftretende Temperaturspitzen an eingebetteten elektronischen Bauelementen ausgleichen.

Schließlich kann es von Vorteil sein, wenn der Schaum elektrisch leitfähig ist. Wenn ein solcher Schaum in einem Kompartment der Einheit angeordnet wird, in dem sich ein Steckkontakt befindet, kann die Kontaktbildung durch den Schaum unterstützt werden.

Weil eine elektronische Steuereinheit für eine Lenkkraftunterstützungseinheit, mit einem mehrteiligen Gehäuse, das eine in einem Innenraum des Gehäuses angeordnete elektronische Schaltung umschließt, und mit wenigstens einem Steckkontakt, der eine Anzahl das Gehäuse durchsetzende elektrische Kontaktelemente aufweist, die außerhalb des Innenraums angeordnete Kontaktflächen aufweisen und in den Innenraum hinein reichen, wo sie mit der elektronischen Schaltung verbunden sind wobei ein erstes Gehäuseteil mit einem zweiten Gehäuseteil über einen geschlossenporigen Schaum miteinander verbunden ist, wodurch eine unlösbare Verbindung der Gehäuseteile gebildet wird, wirkt der Schaum dadurch als Klebstoff zwischen den Gehäuseteilen, sodass die Gehäuseteile dadurch gehalten, gerichtet und verschlossen werden können. Dies hat den Vorteil, dass eine Schraubverbindung zwischen den Gehäuseteilen entfällt, sodass Bauteile und Bearbeitungsschritte an den Gehäuseteilen entfallen. Hierzu kann mindestens eines der Gehäuseteile mindestens eine Einfüllöffnung zum Einfüllen des Schaums aufweisen.

Nachfolgend werden Ausführungsbeispiele der vorliegenden Erfindung anhand der Zeichnung näher beschrieben. Gleiche oder funktionsgleiche Bauelemente sind dabei mit den gleichen Bezugsziffern versehen. Es zeigen:
- Figur 1:: eine schematische Darstellung einer Kraftfahrzeuglenkung mit elektrischer Hilfskraftunterstützung;
- Figur 2:: eine elektronische Steuereinheit für eine elektrische Hilfskraftlenkung in einer perspektivischen Darstellung;
- Figur 3:: die Steuereinheit aus Figur 2 in einer Draufsicht auf die Anschlussseite;
- Figur 4:: die Steuereinheit aus Figur 2 und 3 in einer perspektivischen Darstellung mit abgenommenem Gehäusedeckel;
- Figur 5:: die Steuereinheit in einem Längsschnitt entlang der Linie V-V aus Figur 3;
- Figur 6:: eine schematische Darstellung der Schaumstruktur aus dem gekennzeichneten Bereich des Innenraums der Figur 5;
- Figur 7:: eine Steuereinheit in der Darstellung gemäß Figur 5 mit nur partiell ausgeschäumten Bereichen; sowie
- Figur 8:: einer Steuereinheit in einer anderen Schnittdarstellung, ebenfalls mit partiell ausgeschäumten Bereichen.

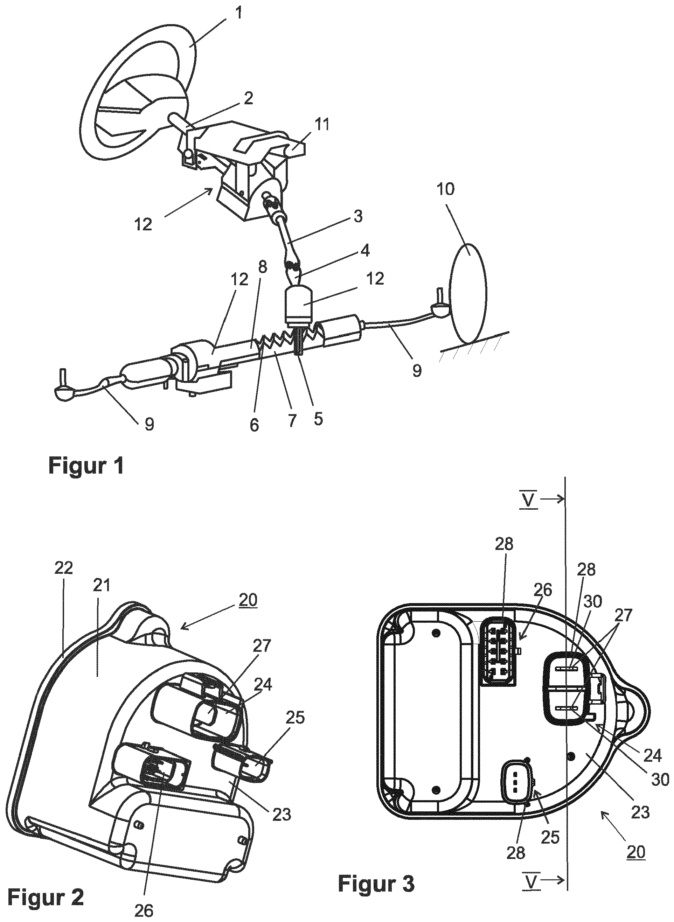

Die Figur 1 zeigt eine elektromechanische Servolenkung in einer prinzipiellen Darstellung. Die Servolenkung umfasst in bekannter Weise ein Lenkrad 1, das drehfest mit einer oberen Lenkwelle 2, einer unteren Lenkwelle 3 und einer Ritzelwelle 4 gekoppelt ist. Die Ritzelwelle 4 trägt an ihrem dem Lenkrad 1 abgewandten Ende ein Ritzel 5, das mit einer Verzahnung 6 einer Zahnstange 7 in Eingriff steht. Die Zahnstange 7 wiederum ist in einem Lenkungsgehäuse 8 verschieblich gelagert und trägt an ihren Enden jeweils eine Spurstange 9. Die Spurstangen 9 sind in bekannter Weise mit nicht dargestellten Achsschenkeln einer lenkbaren Achse verbunden, sodass eine Drehung des Lenkrades 1 zu einer Verschiebung der Zahnstange 7 und damit zu einer Verschwenkung von lenkbaren Rädern 10 im Betrieb führt. Die Figur 1 soll nur als prinzipielle Darstellung verstanden werden, weil hier insgesamt drei mögliche Anordnungen von Servoantrieb dargestellt sind. Eine erste mögliche Anordnung befindet sich im Bereich der oberen Lenkwelle 2 an einer Lenksäule 11. Eine dort angeordnete Lenkkraftunterstützungseinheit 12 treibt direkt die Lenkwelle 2 an. Diese Anordnung wird Englisch "column drive" genannt. Eine zweite mögliche Anordnung der Lenkkraftunterstützungseinheit 12 befindet sich an der Ritzelwelle 4. Der Servoantrieb treibt dabei unmittelbar das Ritzel 5 an. Diese Anordnung wird "pinion drive" genannt. Schließlich kann eine Lenkkraftunterstützungseinheit 12 auch in dem Lenkungsgehäuse 8 angeordnet sein und unmittelbar auf die Zahnstange 7 wirken. Diese Ausführungsform wird "rack drive" genannt. Die vorliegende Erfindung ist für alle drei genannten Varianten einer elektromechanischen Lenkung gleichermaßen einsetzbar.

Bei allen drei Varianten ist als Antrieb ein Elektromotor vorgesehen, der üblicherweise als bürstenloser, elektronisch kommutierter Motor ausgebildet ist. Dieser Motor wird unmittelbar von einer elektronischen Steuerung angesteuert, die in einer Steuereinheit integriert ist. Die Steuereinheit umfasst dabei eine Vielzahl von elektronischen Komponenten, die für die Umwandlung von Steuerimpulsen in Ansteuerungssignale für den Elektromotor erforderlich sind, sowie insbesondere auch Komponenten der Leistungselektronik, die die Stromversorgung für den Motor bewirken. Die Steuereinheit ist bei elektromechanischen Kraftfahrzeuglenkungen üblicherweise mit einem eigenen Gehäuse versehen und direkt an dem Gehäuse des Elektromotors angeordnet. Bei den beiden letztgenannten Bauarten einer elektromechanischen Servolenkung befindet sich das Gehäuse der Steuereinheit im Motorraum oder unmittelbar an der Achse des Fahrzeugs und deshalb in einem Bereich, der durch Temperaturschwankungen, Nässe und Schmutz belastet ist.

Die Figur 2 zeigt eine elektronische Steuereinheit 20 einer Lenkkraftunterstützungseinheit 12 in einer perspektivischen Darstellung. Die Steuereinheit 20 umfasst ein zweites Gehäuseteil 22, welches fortan als Gehäuse 22 bezeichnet wird, dass an einer Seite von einem ersten Gehäuseteil 21, welches fortan als Gehäusedeckel 21 bezeichnet wird, verschlossen ist. An einer Rückseite 23 der Steuereinheit 20 sind Steckanschlüsse 24,25 und 26 angeordnet. Die Steckanschlüsse 24,25 und 26 dienen zur Verbindung der Steuereinheit 20 mit einem nicht dargestellten Kabelbaum des Drehmomentensensors. Die Steckverbindungen 24,25 und 26 weisen in bekannter Weise metallische Kontaktelemente mit einer von außen zugänglichen, nicht isolierend beschichteten metallischen Kontaktfläche 27 auf. In der Figur 2 ist nur die Kontaktfläche 27 der Steckverbindung 24 mit einer Bezugsziffer bezeichnet, da diese am besten erkennbar ist. Die Kontaktfläche 27 der Steckverbindung 24 ist im Vergleich zu den Kontaktflächen der Steckverbindungen 25 und 26 sehr großflächig ausgebildet, weil die Steckverbindung 24 für die allgemeine Stromversorgung des Elektromotors vorgesehen ist, die hohe Stromstärken erfordert.

Die Figur 3 zeigt die Steuereinheit 20 aus Figur 2 in einer Draufsicht auf die Anschlussseite. Die Steckverbindung 24 weist einen äußeren Mantel 28 auf, der den dazu passenden Stecker des Kabelbaums mechanisch führt und in der Endposition verriegelt. Ein Kontaktelement 30, das die Kontaktfläche 27 trägt, ist in an sich bekannter Weise als bandförmiges, metallisches Kontaktelement ausgeführt und in seiner Längserstreckung senkrecht zu der Ebene der Rückseite 23 orientiert. Das Kontaktelement 30 durchsetzt dabei die Wandung des Gehäusedeckels 21 und ist im Innern der Steuereinheit 20 mit einer elektronischen Schaltung verbunden. Entsprechendes gilt für die anderen Kontaktelemente in den Steckverbindungen 25 und 26. Auch diese sind aus Metall gefertigt und als bandförmige oder stiftförmige Kontakte ausgeführt, die vom Außenraum in den Innenraum der Steuereinheit 20 reichen.

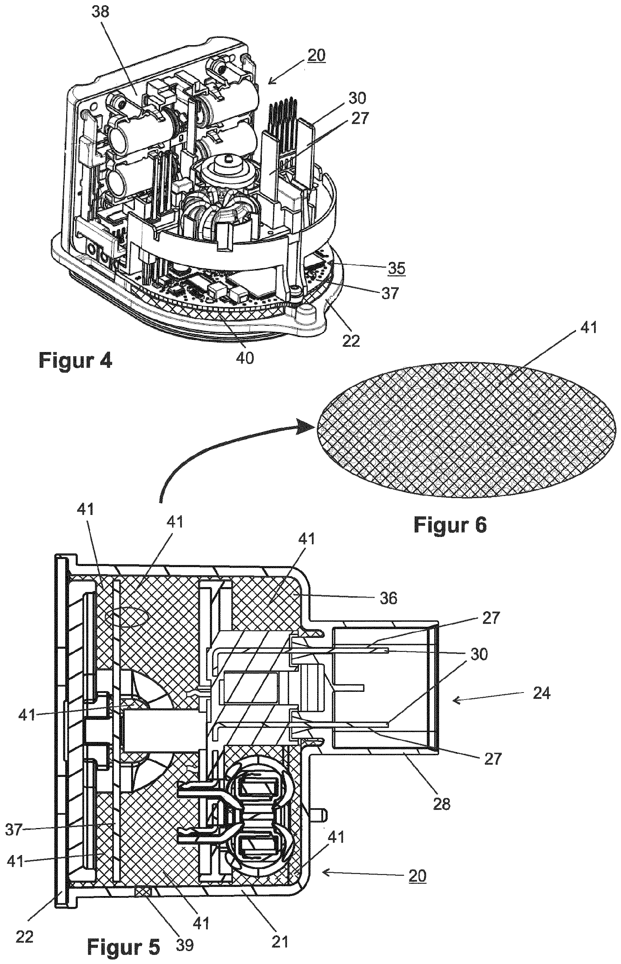

Die Steuereinheit 20 ist mit abgenommenem Gehäusedeckel in der Figur 4 perspektivisch dargestellt. Die Kontakteelemente, insbesondere die Kontakte 30 der Steckverbindung 24, sind befestigt auf einer elektronischen Schaltung 35, die sich in einem von dem Gehäusedeckel 21 umschlossenen Innenraum 36 befindet. Die elektronische Schaltung 35 umfasst eine erste Platine 37, auf der sich Steuerungskomponenten mit relativ geringem Leistungsbedarf befinden. Eine weitere Platine 38 ist etwa rechtwinklig zu der Platine 37 orientiert und trägt vor allem Bauelemente der Leistungselektronik, die zur unmittelbaren Ansteuerung des Elektromotors dienen und die im Betrieb erhebliche Wärmemengen produzieren. Zwischen der Platine 37 und der Unterseite des Gehäuses 22 ist der Innenraum in diesem Ausführungsbeispiel mit einem Schaum 40 ausgefüllt. Der Schaum 40 füllt dabei den gesamten Raum zwischen der Platine und dem Gehäuse 22 aus. Er kann dabei beispielsweise dazu dienen, aufgrund des Herstellungsprozesses dort angefallene Partikel aus Kunststoff oder auch Metall zu fixieren und diese so daran zu hindern, sich unkontrolliert im übrigen Innenraum 36 zu bewegen.

Die Figur 5 zeigt die Steuereinheit 20 aus Figur 3 in einem Längsschnitt entlang der Linie V-V. In diesem Ausführungsbeispiel ist der Gehäusedeckel 21 auf das Gehäuse 22 aufgesetzt. Der Aufbau der Steckverbindung 24 mit dem Mantel 28 und den Kontaktelementen 30 ist in dieser Darstellung im Schnitt deutlich erkennbar. Ein Schaum 41 ist in dem gesamten Innenraum 36 angeordnet, sodass er sowohl an dem Gehäuse 22 als auch an dem Gehäusedeckel 21 vollflächig anliegt und insbesondere die Platine 37 vollständig umschließt. Dieses vollständige Ausschäumen des Innenraums 36 bewirkt insbesondere auch, dass die Kontaktelemente 30, die den Gehäusedeckel 21 durchsetzen, von dem Schaum 41 umgeben sind, wo sie in dem Innenraum 36 frei liegen. Diese Maßnahme ist vorteilhaft, weil die Kontaktelemente 30, wie in der Figur 4 dargestellt wurde, auf der elektronischen Schaltung befestigt sind und der Deckel 21 Öffnungen aufweist, die beim Aufsetzen des Gehäusedeckels 21 auf das Gehäuse 22 den Durchgang der Kontaktelemente 30 durch den Gehäusedeckel 21 erlauben. Dabei ist nicht immer sichergestellt, dass die Kontaktelemente 30 die entsprechende Durchgangsöffnung des Gehäusedeckels 21 vollständig dicht verschließen. Bei der Montage wird zwar ein Stecker auf die Steckverbindung 24 aufgesetzt, der dann mit dem Mantel 28 eine Abdichtung bewirkt. Eventuell im Innenraum der Steckverbindung 24 vorhandene Partikel könnten jedoch in einem ungünstigen Fall zwischen dem Gehäusedeckel 21 und dem Kontaktelement 30 in den Innenraum 36 der Steuereinheit 20 wandern. Das vollständige Ausschäumen mit Schaum 41, wie in Figur 5 dargestellt, verhindert in diesem Fall das Eindringen von Partikeln. Das Ausschäumen des Innenraums 36 erfolgt in diesem Fall nach dem Aufsetzen des Gehäusedeckels 21 auf das Gehäuse 22. Der Gehäusedeckel 21 hat eine Einfüllöffnung 39, in welche der Schaum 41 eingespritzt werden kann. Die Einfüllöffnung 39 kann auch am Gehäuse 22 vorgesehen sein. Das Einfüllen des Schaums 41 erfolgt nachdem der Gehäusedeckel 21 auf das Gehäuse 22 aufgesteckt worden ist.

Dadurch werden eingeschlossene Partikel sicher im Schaum fixiert und gleichzeitig die Gehäuseteile 21,22 fest miteinander verbunden. Dadurch entfallen Fixiermittel zwischen den Gehäuseteilen 21, wie beispielsweise Verbindungsschrauben. Weiterhin ermöglicht das Aufspritzen des Schaums 41 durch die Einfüllöffnung 39, dass mehrere Bauteile innerhalb der Gehäuseteile 21,22, wie beispielsweise die Platine 37,38 und die auf ihr angeordneten Elemente, miteinander unlösbar fixiert werden.

Die Struktur des Schaums 41 soll in der Figur 6 beispielhaft veranschaulicht werden. Es handelt sich bei dem Schaum 41 um einen geschlossenporigen Schaum, insbesondere einen einkomponentigen oder zweikomponentigen Kunstharzschaum mit einer Reißdehnung von 20 % oder mehr. Der Kunstharzschaum weist eine große Anzahl von internen Blasen auf, die einen geringen Durchmesser von vorzugsweise unter 1 mm aufweisen. Näheres zu den Eigenschaften des verwendeten Schaums ist weiter oben in der Beschreibung dargelegt. Aufgrund der Reißdehnung von 20 % oder mehr wird der Schaum auch bei unvermeidbaren mechanischen Belastungen aufgrund von Erschütterungen, Vibrationen und Temperaturdifferenzen im Betrieb nicht reißen. Eingeschlossene Partikel werden deshalb sicher fixiert und nicht wieder freigesetzt. Der Schaum selbst setzt ebenfalls keine Partikel frei, wie sie bei harten, unelastischen Schäumen mit geringerer Reißdehnung mit der Zeit an den Bruchstellen entstehen können.

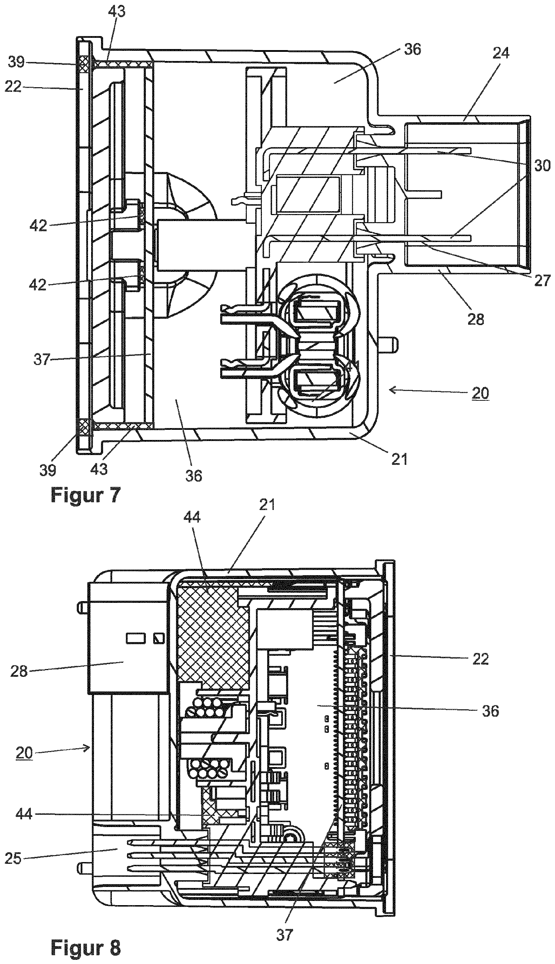

In der Figur 7 ist ein Schnitt entsprechend Figur 5 dargestellt. Bei diesem Ausführungsbeispiel ist der Innenraum 36 im Wesentlichen nicht ausgeschäumt. Ein Schaum 42 ist hier nur an der Unterseite der Platine 37 angebracht, und zwar auch nur in dem dargestellten mittigen Bereich, der nicht beschichtete Leiterbahnen aufweist. Die Leiterbahnen werden von dem Schaum 42 bedeckt, so dass die Gefahr von Kurzschlüssen oder anderen Störungen durch fremde metallische Partikel in diesem Bereich gezielt gebannt wird. Ein weiterer Schaum 43 ist jeweils am äußeren Umfang des Gehäusedeckels 21 in dem Bereich zwischen der Platine 37 und dem Gehäuse 22 vorgesehen. Der Schaum 43 ist adhäsiv mit dem Gehäusedeckel 21 und dem Gehäuse 22 sowie mit dem äußeren Rand der Platine 37 verbunden und dichtet somit den Innenraum 36 im Bereich der Fügestelle zwischen dem Gehäusedeckel 21 und dem Gehäuse 22 gegenüber dem dahinterliegenden Bereich des Gehäuses 22 oder dem Innenraum 36 ab. Dieses Ausführungsbeispiel soll veranschaulichen, dass erfindungsgemäß Schäume selektiv zum Abdichten oder Abdecken eingesetzt werden können und nicht notwendigerweise den gesamten Innenraum 36 ausfüllen müssen. Es kann alternativ oder zusätzlich vorgesehen sein, Schäume wie den Schaum 42 oder den Schaum 43 auch an anderen Stellen der Steuereinheit 20 vorzusehen. Weiterhin ist in Figur 7 dargestellt, dass der Gehäusedeckel 21 mit dem Gehäuse 22 partiell verklebt werden kann. Dazu weist das Gehäuse 22 Einfüllungsöffnungen 39 auf, in welche der Schaum 43 eingespritzt werden kann. In der Figur 8 ist schließlich die Steuereinheit 20 in einer anderen Ansicht im Schnitt dargestellt. Bei diesem Ausführungsbeispiel ist ein Schaum 44 gezielt in einem Bereich des Innenraums 36 angeordnet, der dem Steckverbinder 28 unmittelbar benachbart ist. Der Schaum 44 kann dabei in den Bereich reichen, der in der Figur 8 hinter der Schnittebene liegt. Dieser Bereich enthält die Platine 37 mit den Komponenten der Leistungselektronik. Der Schaum 44 kann in diesem Ausführungsbeispiel mit Graphitpartikeln, Paraffin oder beidem als Füllstoff gefüllt sein. Graphit erhöht die Wärmeleitfähigkeit des Schaums 44. Paraffin erhöht die Wärmekapazität des Schaums 44. Eine erhöhte Wärmeleitfähigkeit dient dazu, im Betrieb die entstehende Wärme der Leistungselektronik abzuleiten. Für eine verbesserte Wärmeleitfähigkeit kann der Schaum in einem bestimmten Wellenlängenbereich, beispielsweise im Infrarotbereich, durchsichtig sein. Eine erhöhte Wärmekapazität des Schaums 44 dient dazu, die bei Leistungsspitzen entstehende Wärmemenge kurzfristig aufzunehmen und dadurch die Leistungselektronik zusätzlich zu kühlen und vor Beschädigung zu schützen.

In allen Ausführungsbeispielen können die Schäume 40 - 44 als nicht vollständig vernetzte Schäume ausgebildet sein. Diese Ausführung hat im Betrieb den Vorteil, dass auch langfristig über die gesamte vorgesehene Betriebsdauer der Steuereinheit 20 eventuell entstehende Risse oder andere strukturelle Schäden in dem Schaum durch dann fortschreitende Vernetzung selbsttätig geheilt werden können. Es ist auch denkbar und möglich den Schaum in Form von Schaumfolie zu verwenden. Die Schaumfolie ist wasserdicht, temperaturdurchlässig und elastisch.

## Patentansprüche

1. Elektronische Steuereinheit (20) für eine Lenkkraftunterstützungseinheit (12), mit einem mehrteiligen Gehäuse (21, 22), das eine in einem Innenraum (36) des Gehäuses (21, 22) angeordnete elektronische Schaltung (37, 38) umschließt, und mit wenigstens einem Steckkontakt (24, 25, 26), der eine Anzahl das Gehäuse durchsetzende elektrische Kontaktelemente (30) aufweist, die außerhalb des Innenraums (36) angeordnete Kontaktflächen (27) aufweisen und in den Innenraum (36) hinein reichen, wo sie mit der elektronischen Schaltung (37, 38) verbunden sind, wobei der Innenraum (36) teilweise oder ganz mit einem geschlossenporigen Schaum (40 - 44) ausgeschäumt ist, **dadurch gekennzeichnet, dass** der Schaum (40 - 44) ein elastischer Schaum mit einer Reißdehnung von mehr als 5% ist.

2. Elektronische Steuereinheit (20) für eine Lenkkraftunterstützungseinheit (12), mit einem mehrteiligen Gehäuse (21, 22), das eine in einem Innenraum (36) des Gehäuses (21, 22) angeordnete elektronische Schaltung (37, 38) umschließt, und mit wenigstens einem Steckkontakt (24, 25, 26), der eine Anzahl das Gehäuse durchsetzende elektrische Kontaktelemente (30) aufweist, die außerhalb des Innenraums (36) angeordnete Kontaktflächen (27) aufweisen und in den Innenraum (36) hinein reichen, wo sie mit der elektronischen Schaltung (37, 38) verbunden sind, **dadurch gekennzeichnet, dass** ein erstes Gehäuseteil (21) mit einem zweiten Gehäuseteil (22) über einen geschlossenporigen Schaum (40-44) miteinander verbunden werden, wodurch eine unlösbare Verbindung der Gehäuseteile (21,22) gebildet ist.

3. Steuereinheit nach Anspruch 1 oder 2, **dadurch gekennzeichnet, dass** die Reißdehnung des Schaums (40 - 44) mindestens 10% beträgt.

4. Steuereinheit nach einem der vorhergehenden Ansprüche, **dadurch gekennzeichnet, dass** der Schaum (40 - 44) Blasen mit einem Durchmesser von im Mittel weniger als 1 mm, vorzugsweise weniger als 0,1 mm enthält.

5. Steuereinheit nach einem der vorhergehenden Ansprüche, **dadurch gekennzeichnet, dass** der Schaum (40 - 44) zwischen 1.000 und 100.000 Blasen pro cm³ aufweist.

6. Steuereinheit nach einem der vorhergehenden Ansprüche, **dadurch gekennzeichnet, dass** der Schaum (40 - 44) bei einer mittleren Blasengröße von weniger als 0,1 mm zwischen 100.000 und 800.000 Blasen pro cm³ aufweist.

7. Steuereinheit nach einem der vorhergehenden Ansprüche, **dadurch gekennzeichnet, dass** der Schaum (40 - 44) ein Kunstharzschaum mit eingebetteten Partikeln aus einem gummielastischen Material ist.

8. Steuereinheit nach einem der vorhergehenden Ansprüche, **dadurch gekennzeichnet, dass** der Schaum (40 - 44) nicht vollständig vernetzt und bei Rissbildung selbstreparierend ist.

9. Steuereinheit nach einem der vorhergehenden Ansprüche, **dadurch gekennzeichnet, dass** der Schaum (40 - 44) Graphitpartikel als Füllstoff enthält.

10. Steuereinheit nach Anspruch 9, **dadurch gekennzeichnet, dass** der Schaum (40 - 44) zwischen 3 Gew.% und 20 Gew.% Graphitpartikel enthält.

11. Steuereinheit nach einem der vorhergehenden Ansprüche, **dadurch gekennzeichnet, dass** der Schaum (40 - 44) Paraffin als Füllstoff enthält.

12. Steuereinheit nach Anspruch 10, **dadurch gekennzeichnet, dass** der Schaum (40 - 44) zwischen 3 Gew.% und 20 Gew.% Paraffin enthält.

## Claims

1. An electronic control unit (20) for a power steering unit (12), with a multi-part housing (21, 22), which encloses an electronic circuit (37, 38) arranged in an interior space (36) of the housing (21, 22), and with at least one plug contact (24, 25, 26), which comprises a number of electrical contact elements (30) which extend through the housing, comprise contact surfaces (27) arranged outside the interior space (36) and reach into the interior space (36), where they are connected to the electronic circuit (37, 38), wherein the interior space (36) is partially or completely filled with a closed-cell foam (40 - 44), **characterized in that** the foam (40 - 44) is an elastic foam with an elongation at break of more than 5%.

2. An electronic control unit (20) for a power steering unit (12), with a multi-part housing (21, 22), which encloses an electronic circuit (37, 38) arranged in an interior space (36) of the housing (21, 22), and with at least one plug contact (24, 25, 26), which comprises a number of electrical contact elements (30) which extend through the housing, comprise contact surfaces (27) arranged outside the interior space (36) and reach into the interior space (36), where they are connected to the electronic circuit (37, 38), **characterized in that** a first housing part (21) is connected to a second housing part (22) by way of a closed-cell foam (40-44), whereby an undetachable connection of the housing parts (21, 22) is formed.

3. The control unit as claimed in claim 1 or 2, **characterized in that** the elongation at break of the foam (40 - 44) is at least 10%.

4. The control unit as claimed in one of the preceding claims, **characterized in that** the foam (40 - 44) contains bubbles with a diameter of on average 1 mm, preferably less than 0.1 mm.

5. The control unit as claimed in one of the preceding claims, **characterized in that** the foam (40 - 44) comprises between 1000 and 100 000 bubbles per cm³.

6. The control unit as claimed in one of the preceding claims, **characterized in that** the foam (40 - 44), with an average bubble size of less than 0.1 mm, comprises between 100 000 and 800 000 bubbles per cm³.

7. The control unit as claimed in one of the preceding claims, **characterized in that** the foam (40 - 44) is a synthetic resin foam with embedded particles of a rubber-elastic material.

8. The control unit as claimed in one of the preceding claims, **characterized in that** the foam (40 - 44) is not completely crosslinked and, if there is crack formation, is self-repairing.

9. The control unit as claimed in one of the preceding claims, **characterized in that** the foam (40 - 44) contains graphite particles as a filler.

10. The control unit as claimed in claim 9, **characterized in that** the foam (40 - 44) contains between 3% by weight and 20% by weight of graphite particles.

11. The control unit as claimed in one of the preceding claims, **characterized in that** the foam (40 - 44) contains paraffin as a filler.

12. The control unit as claimed in claim 10, **characterized in that** the foam (40 - 44) contains between 3% by weight and 20% by weight of paraffin.

## Revendications

1. Unité de commande électronique (20) pour une unité de direction assistée (12), comprenant un boîtier (21, 22) en plusieurs parties qui renferme un circuit électronique (37, 38) disposé dans un espace intérieur (36) du boîtier (21, 22), et au moins un contact enfichable (24, 25, 26) qui présente un certain nombre d'éléments de contact électriques (30) traversant le boîtier, qui présentent des surfaces de contact (27) disposées à l'extérieur de l'espace intérieur (36), et qui parviennent jusqu'à l'intérieur de l'espace intérieur (36) où ils sont reliés au circuit électronique (37, 38), l'espace intérieur (36) étant partiellement ou entièrement rempli d'une mousse à pores fermés (40 à 44),
**caractérisée en ce que** la mousse (40 à 44) est une mousse élastique ayant une élongation à la rupture de plus de 5 %.

2. Unité de commande électronique (20) pour une unité de direction assistée (12), comprenant un boîtier (21, 22) en plusieurs parties qui renferme un circuit électronique (37, 38) disposé dans un espace intérieur (36) du boîtier (21, 22), et au moins un contact enfichable (24, 25, 26) qui présente un certain nombre d'éléments de contact électriques (30) traversant le boîtier, qui présentent des surfaces de contact (27) disposées à l'extérieur de l'espace intérieur (36), et qui parviennent à l'intérieur de l'espace intérieur (36) où ils sont reliés au circuit électronique (37, 38) ,
**caractérisée en ce qu'**une première partie de boîtier (21) est reliée à une deuxième partie de boîtier (22) par l'intermédiaire d'une mousse à pores fermés (40 à 44) de manière à former un assemblage inamovible des parties de boîtier (21, 22).

3. Unité de commande selon la revendication 1 ou 2, **caractérisée en ce que** l'élongation à la rupture de la mousse (40 à 44) est d'au moins 10 %.

4. Unité de commande selon l'une quelconque des revendications précédentes, **caractérisée en ce que** la mousse (40 à 44) contient des bulles d'un diamètre de moins de 1 mm, de préférence de moins de 0,1 mm, en moyenne.

5. Unité de commande selon l'une quelconque des revendications précédentes, **caractérisée en ce que** la mousse (40 à 44) présente entre 1000 et 100 000 bulles par cm³.

6. Unité de commande selon l'une quelconque des revendications précédentes, **caractérisée en ce que** la mousse (40 à 44) présente entre 100 000 et 800 000 bulles par cm³ pour une taille de bulle moyenne de moins de 0,1 mm.

7. Unité de commande selon l'une quelconque des revendications précédentes, **caractérisée en ce que** la mousse (40 à 44) est une mousse plastique dotée de particules incorporées en matériau élastique.

8. Unité de commande selon l'une quelconque des revendications précédentes, **caractérisée en ce que** la mousse (40 à 44) n'est pas entièrement réticulée et est autoréparable en cas de fissuration.

9. Unité de commande selon l'une quelconque des revendications précédentes, **caractérisée en ce que** la mousse (40 à 44) contient des particules de graphite comme matière de charge.

10. Unité de commande selon la revendication 9, **caractérisée en ce que** la mousse (40 à 44) contient entre 3 % en poids et 20 % en poids de particules de graphite.

11. Unité de commande selon l'une quelconque des revendications précédentes, **caractérisée en ce que** la mousse (40 à 44) contient de la paraffine comme matière de charge.

12. Unité de commande selon la revendication 10, **caractérisée en ce que** la mousse (40 à 44) contient entre 3 % en poids et 20 % en poids de paraffine.
